(19) Europäisches Patentamt
European Patent Office
Office européen des brevets

(11) **EP 2 212 705 B1**

(12) **EUROPÄISCHE PATENTSCHRIFT**

(45) Veröffentlichungstag und Bekanntmachung des Hinweises auf die Patenterteilung:
**17.10.2018 Patentblatt 2018/42**

(21) Anmeldenummer: **08855042.1**

(22) Anmeldetag: **24.11.2008**

(51) Int Cl.:
*G01R 29/08* (2006.01)      *H01Q 21/00* (2006.01)
*G01S 3/74* (2006.01)

(86) Internationale Anmeldenummer:
**PCT/DE2008/001933**

(87) Internationale Veröffentlichungsnummer:
**WO 2009/067997 (04.06.2009 Gazette 2009/23)**

(54) **WELLENFELDANALYSEVERFAHREN UND -GERÄT**

EMC ANALYSIS DEVICE

APPAREIL D'ANALYSE EMV

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **29.11.2007 EP 07023135**

(43) Veröffentlichungstag der Anmeldung:
**04.08.2010 Patentblatt 2010/31**

(73) Patentinhaber: **Lambda: 4 Entwicklungen GmbH 22767 Hamburg (DE)**

(72) Erfinder: **REIMANN, Rönne 22769 Hamburg (DE)**

(74) Vertreter: **Raffay & Fleck Patentanwälte Grosse Bleichen 8 20354 Hamburg (DE)**

(56) Entgegenhaltungen:
**EP-A- 1 703 297     US-B1- 6 233 459**

- **RICHTER A ET AL: "DoA and Polarization Estimation using Arbitrary Polarimetric Array Configurations" SENSOR ARRAY AND MULTICHANNEL SIGNAL PROCESSING, 2006. IEEE WORKSHOP JULY 12, 2006, PISCATAWAY, NJ, USA,IEEE, 12. Juli 2006 (2006-07-12), Seiten 55-59, XP010941391 ISBN: 978-1-4244-0308-0**
- **"Optimal Polarized Waveform Design for Active Target Parameter Estimation Using Electromagnetic Vector Sensors" ACOUSTICS, SPEECH AND SIGNAL PROCESSING, 2006. ICASSP 2006 PROCEEDINGS . 2006 IEEE INTERNATIONAL CONFERENCE ON TOULOUSE, FRANCE 14-19 MAY 2006, PISCATAWAY, NJ, USA,IEEE, 1. Januar 2006 (2006-01-01), Seiten V-V, XP031101711 ISBN: 978-1-4244-0469-8**
- **ALMIDFA K ET AL: "Improved DOA estimation using polarisation diversity: simulations using a wideband propagation model" PERSONAL, INDOOR AND MOBILE RADIO COMMUNICATIONS, 2000. PIMRC 2000. TH E 11TH IEEE INTERNATIONAL SYMPOSIUM ON SEPT. 18-21, 2000, PISCATAWAY, NJ, USA,IEEE, Bd. 1, 18. September 2000 (2000-09-18), Seiten 539-543, XP010520695 ISBN: 978-0-7803-6463-9**

**EP 2 212 705 B1**

**Beschreibung**

Die Erfindung betrifft ein Verfahren sowie eine Vorrichtung zur Analyse eines Wellenfeldes gemäß den Merkmalen der Ansprüche 1 und 9.

Es ist bekannt, Wellenfelder durch verschiedene Anordnungen von Empfangsvorrichtungen zu analysieren. Beispielsweise werden drehende Anordnungen von Empfangsvorrichtungen zur Bestimmung der Einfallsrichtung verwendet. Auch ist es bekannt, die Signale von mehreren statisch angeordneten Empfangsvorrichtungen auszuwerten.

Insbesondere ist es bekannt, dazu eine Arrayresponse der verwendeten Empfangsvorrichtungsanordnung zu verwenden. Eine Arrayresponse gibt an, welches Signal der Empfangsvorrichtungsanordnung zu entnehmen ist, wenn eine bestimmte Strahlung auf die Empfangsvorrichtungsanordnung einwirkt. Dementsprechend kann eine Arrayresponse berechnet oder durch Kalibration gewonnen werden. Eine vorbekannte Arrayresponse ist entweder eine Funktion oder besteht aus einer Menge von Objekten. Eine Arrayresponse als Funktion ist eine Zuordnung zwischen den Eigenschaften einer einfallenden Welle (Frequenz (f), Einfallsrichtung (alpha, phi), Polarisation, Wellenfrontkrümmung, Feldstärke)) und den von den einzelnen Empfangsvorrichtungen gelieferten Signalen, die in der Regel als komplexe Zahlen dargestellt werden. Somit handelt es sich bei einer solchen Funktion meistens um eine komplexe Funktion mehrerer Variablen.

Als Menge von Objekten besteht die Arrayresponse aus einer Menge von Arrayresponsekomponenten, die jeweils Vektoren der von den einzelnen Empfangsvorrichtungen gelieferten Signale sind. Diese Vektoren sind einer Kombination von Ausprägungen mindestens einer Eigenschaft (z.B. Frequenz, Amplitude, Richtung) einer einfallenden Welle zugeordnet.

Das bedeutet, dass ein solcher Vektor in der Regel so viele komplexe Zahlen beinhaltet, wie Empfangsvorrichtungen vorgesehen sind. Die Arrayresponse setzt sich dann aus einer Vielzahl solcher Vektoren für unterschiedliche Ausprägungen von Eigenschaften der einfallenden Welle, wie z.B. Frequenz und Einfallsrichtung, zusammen.

Arrayresponsekomponenten solcher vorbekannten Arrayresponsen werden im Folgenden zur klaren begrifflichen Trennung als eindimensionale Arrayresponsekomponenten bezeichnet, da die einzelnen Komponenten, also Vektoren, jeweils in eine Richtung zeigen und somit nur ein eindimensionales Objekt darstellen.

Die vorbekannten Arrayresponsen sind unterschiedlich differenzierend, beinhalten als Variablen unterschiedliche Mengen von Eigenschaften von Wellen. Beispielsweise können Polarisation und Wellenfrontkrümmung vernachlässigt oder bei bestimmten Anwendungen nicht erforderlich sein, und stattdessen insbesondere die Einfallsrichtung von Interesse sein. Wenn dazu auf Grund der Gegebenheiten die Berücksichtigung der Parameter f, phi und alpha ausreicht, dann könnte eine Arrayresponse eine komplexe vektorielle Funktion der Form A(alpha, phi, f) sein. Wenn dabei die Arrayresponse aus einzelnen Vektoren besteht, könnte sie aus der Menge der komplexen Vektoren $A_{alpha(k),phi(l)f(n)}$ bestehen. Wobei k, l, n natürliche Indizes sind und verschiedene Winkel im Bereich von für alpha (0;360( und für phi(0;180( und Frequenzen f indizieren. Arbeitet man beispielsweise mit Frequenzen im Bereich von 1 bis 10 Herz und will man den gesamten Raum abdecken und eine Auflösung von delta f = 1 Herz und delta phi = delta alpha = 6° erreichen, besteht die Arrayresponse aus 10 x 60 x 30 = 18 000 Vektoren. Diese Vektoren sind Vektoren der Messwerte, also komplexer Zahlen (Amplitude und Phase), und besitzen die Dimension a, wobei a die Anzahl der Empfangsvorrichtungen ist.

Des Weiteren ist es bekannt, aus den die komplexen Messwerte der a Empfangsvorrichtungen (Amplitude und Phase) enthaltenden Messwertvektoren $m_i$ verschiedener Messungen i, wobei die Messungen Messungen unkorrelierter Signale oder dekorrelierte Messungen (z.B. durch Messungen auf unterschiedlichen Frequenzen) sind, die Matrix M zu bilden, deren i Spalten die $m_i$ Messwertvektoren bilden. Aus dieser Matrix M wird denn die Autokorrelationsmatrix AKM = $E(MM^H)$ berechnet, wobei $M^H$ die komplex konjugierte Transponierte von M ist und E(M) die normierte von M ist. Aus dieser AKM können Eigenvektoren EV und Eigenwerte EW berechnet werden. An Hand der Eigenwerte ist es bekannt, zu versuchen Rauschen von Signal zu trennen. Auch weitere Analysen der AKM, beispielsweise auf Basis ihrer Inversen sind bekannt. Die Ergebnisse werden dann in Bezug zur Arrayresponse gesetzt, um so auf die (wahrscheinlichen, näherungsweisen) Eigenschaften des an der Empfangsvorrichtungsanordnung vorliegenden Wellenfeldes zu schließen. Beispielsweise werden die nach Abtrennung des Rauschanteils auf Basis der Eigenwerte verbleibenden Signalanteile (Unterraum) mit der Arrayresponse verglichen.

Des Weiteren ist es bekannt, eine Arrayresponse einzusetzen, die aus 2Nx2M dimensionalen Matrizen besteht. Dabei ist N die Anzahl der Empfangsvorrichtungen und M die Anzahl der bei einer Zerlegung berücksichtigten Moden. Die Größe der Matrix von 2N ergibt sich daher, dass die verwendeten Antennen jeweils zwei Ausgänge für unterschiedliche Polarisationsrichtungen er einfallenen Strahlung haben.

Den vorbekannten Verfahren ist gemein, dass sie, um große Genauigkeit zu erzielen viel Speicherplatz und/oder Rechenzeit benötigen beziehungsweise auf ausgedehnte Empfangsvorrichtungsanordnungen angewiesen sind.

In der Veröffentlichung Richter A. et al : "DoA and Polarization Estimation using Arbitrary Polarimetric Array Configurations" wird ein vorbekanntes Verfahren beschrieben, bei welchem mittels einer geschlossenen Lösung eines Antennenmodels ein elektromagnetisches Wellenfeld analysiert wird.

Insbesondere treten dann Probleme auf, wenn die Vorrichtung räumlich klein gestaltet, insbesondere als ein handliches, kompaktes Gerät realisiert werden und mit elektromagnetischen Wellen mit Wellenlängen im mm bis cm Bereich gearbeitet werden soll, und/oder die Umgebung inhomogen gestaltet ist. Denn dann tritt auf Grund der im Verhältnis zur Wellenlänge nicht mehr großen räumlichen Ausdehnung der Empfangsvorrichtungsanordnung eine erhebliche Verschlechterung der Auflösung ein. Des Weiteren werden solche, kompakten Geräte anfällig für Einflüsse aus der Umgebung, wie beispielsweise den Bediener und/oder das Gehäuse selbst. Werden beispielsweise mehrere (insbesondere auch in Bezug auf die Polarisation) gleiche Empfangsvorrichtungen (a) angeordnet, sind ihre Ausgangssignale ($S_a$) in Abhängigkeit von der Polarisation (P) der eingestrahlten Welle unterschiedlich, also $S_{a=1}(P) \neq S_{a=2}(P)$. Daher ist es notwendig, dass die Arrayresponse in diesen Fällen die Polarisation als Parameter beinhaltet. Solche Probleme treten bei (im Vergleich zur Wellelänge) sehr ausgedehnten Empfangsvorrichtungsanordnungen in homogener Umgebung kaum auf.

Somit ist es Aufgabe der vorliegenden Anmeldung, bei möglichst geringem Rechenaufwand und Speicherbedarf und bei Verwendung von Platz sparenden Empfangsvorrichtungsanordnungen eine möglichst genaue Analyse eines Wellenfeldes zu ermöglichen.

Dies wird erreicht durch ein Verfahren nach Anspruch 1 und eine Vorrichtung nach Anspruch 9.

Bei den mindestens zwei Messungen handelt es sich nicht vollständig korrelierte, vorzugsweise um dekorrelierte oder unkorrelierte, Messungen. Eine solche Dekorrelation kann durch unterschiedliches Vorgehen erreicht werden. Denkbar ist beispielsweise eine Dekorrelation über die Verwendung unterschiedlicher oder unterschiedlich angeordneter Empfangsvorrichtungen oder über einen geeigneten zeitlichen Abstand zwischen den Messungen.

Dies bedeutet, dass statt der vorbekannten Arrayresponse als vektorielle Funktion oder als Menge von Vektoren erfindungsgemäß eine Menge von Matrizen (mindestens 2 x a) oder eine Matrix-Funktion (mindestens 2 x a) zur Anwendung gelangt.

Durch die Polarisationswinkel p1 und p2 werden Räume, die im hier vorliegendem zweidimensionalen Fall Ebenen sind, aufgespannt. Dies kann so dargestellt werden: Die Arrayresponse ist eine Menge von 2 x a dimensionalen Matrizen, beispielsweise die Menge $A_{alpha(k),phi(l).f(n)}$, der 2 x a dimensionalen komplexen Matrizen wobei k, l, n natürliche Zahlen sind und die verschieden Winkel der Einfallsrichtung alpha (0;360( und phi(0;180( und Frequenzen f indizieren (verschiedene Ausprägungen der Eigenschaften Frequenz und Einfallsrichtung). Dabei ist jedes $A_{alpha(k),phi(l).f(n)}$ jedoch eine Matrix von 2 x a komplexen Zahlen, wobei die komplexen Zahlen die Amplitude und die Phase der Messwerte der a Empfangsvorrichtungen angeben.

Werden die Matrizen so gewählt, dass sie 2 Zeilen und a Spalten aufweisen, so nehmen die Matrizen in der ersten Zeile beispielsweise die komplexen Responsen der a Antennen beim Einfall einer im Winkel p1 polarisierten Welle auf und in der zweiten Zeile die komplexen Responsen der a Antennen beim Einfall einer im Winkel P2 polarisierten Welle auf.

Die Abstandsberechnung zwischen Messwerten oder daraus berechneten oder erstellten Objekten und Arrayresponse kann dabei beispielsweise durch eine Projektion von Messwerten oder daraus berechneten oder erstellten Objekten und der Arrayresponse erfolgen, die nicht unbedingt mathematisch exakt sein muss um zu praktisch geeigneten Ergebnissen zu gelangen. Die Matrix kann dabei beispielsweise die Autokorrelationsmatrix AKM von Messwerten sein. Diese Matrix spannt einen Raum auf. Der Raum kann jedoch auch auf einen Unterraum verkleinert werden. Dies bietet sich insbesondere dann an, wenn beispielsweise durch vorbekannte Verfahren, Rauschanteile aus dem Signal entfernt werden sollen. In diesem Fall bietet es sich an, die Eigenvektoren der AKM zu bestimmen und an Hand dessen den Eigenvektorraum zu ermitteln und von diesem Raum lediglich einen Unterraum (Eigenvektorunterraum) zu verwenden. Dabei ist es besonders vorteilhaft, wenn die Eigenvektoren mit niedrigen Eigenwerten vernachlässigt werden.

Unter Abstandsberechnung ist auch die Bestimmung eines Objektes mit minimalem oder Extremen oder vorbestimmten Abstand zu verstehen.

Mathematisch exakt lässt sich das Problem der Abstandsberechnung beispielsweise wie folgt lösen:
T(z) sei ein Testvektor in dem durch die Summe der Arrayresponsekomponenten aufgespannten komplexen 2 x a Raum und sei $T_p(z)$ definiert durch die folgende Linearkombination aus den Vektoren U1 und U2, die durch die Projektion der zwei komplexen Messwertvektoren oder Spalten der Autokorrelationsmatrix oder von zwei einen aus den Messwerten berechneten (Unter)raum, insbesondere Eigenvektorunterraum der AKM, aufspannenden Vektoren in den durch die Summe der Arrayresponsekomponenten aufgespannten komplexen 2 x a Raum erhalten wurden:
T(z) = z · U1 + U2, wobei z = x + i . y und x und y reelle Zahlen und i Imaginäranteil
P sei die durch zwei komplexe Messwertvektoren oder Spalten der Autokorrelationsmatrix oder von den zwei einen aus den Messwerten berechneten (Unter)raum, insbesondere Eigenvektorunterraum der AKM, aufspannenden Vektoren aufgespannte komplexe Ebene.

Dann ist das "Best-Fit", über das die Eigenschaften der einfallenden Welle (näherungsweise) auf Basis der Arrayresponse beziehungsweise der Inversen der Arrayresponse (bei einer Arrayresponsefunktion) ablesbar sind, die Komponente der Arrayresponse mit dem minimalen Abstand zu P.

Diesen kann man wie folgt ermitteln: Projiziert man T in P und bezeichnet man (wie oben beschrieben) den so erhaltenen Vektor in P mit $T_P$, so lautet das zu lösende Problem: maximiere K(z), wobei

$$K(z) = \frac{\|T_P(z)\|^2}{\|T(z)\|^2}$$

. Dies lässt sich beispielsweise in das reelle Problem

$$\begin{cases} \dfrac{\partial K(x, y)}{\partial x} = 0 \\ \dfrac{\partial K(x, y)}{\partial y} = 0 \end{cases}$$

transferieren und im Anschluss vergleichsweise einfach lösen.

Durch die Verwendung einer erfindungsgemäßen Arrayresponse, ist es möglich, bei Einsparung von Rechenzeit und Speicherbedarf auf kleine Empfangsvorrichtungsanordnungen zurück zugreifen und trotzdem hervorragende Analysen des Wellenfeldes beziehungsweise von Wellenfeldanteilen, beispielsweise bezüglich der Welleneinfallsrichtungen, zu erreichen. Dies ist möglich, da die Projektion mehrdimensionaler Objekte im Vergleich zur Einsparung in Bezug auf die Anzahl der nötigen Berechnungen, nur unwesentlich aufwendiger ist, als die Projektion vorbekannter Objekte und dadurch die Auswertung von mehr Parametern mit höherer Auflösung möglich ist.

Zu der Rechenzeitersparnis kommt die Speicherplatzersparnis hinzu:
Zurückkommend auf das eingangs erwähnte Beispiel, bei dem die Arrayresponse aus 10 x 60 x 30 = 18 000 komplexen Vektoren der Dimension a besteht, berechnet sich der Speicherbedarf bei 10 Empfangsvorrichtungen (a = 10), wenn man die Polarisation mit der gleichen Winkelgenauigkeit auflösen will (6°), und bei Verwendung von 16byte pro komplexem Wert zu mindestens 10 x 60 x 30 x 30 x 16byte = 18 000 x 30 x 16byte = 8,24 MB. Bei Verwendung einer erfindungsgemäßen Arrayresponse reduziert sich der Speicherbedarf, wie sich umgehend erschließt, auf 10 x 60 x 30 x 2 x 16byte = 18 000 x 2 x 16byte = 0,55 MB, also um den Faktor 15. Es ist klar, dass dieser Vorteil umso größer ist, je höher die Dimension der mehrdimensionalen Arrayresponse und je genauer die Auflösung gewählt werden.

Auch die Ersparnis in Bezug auf die Rechenleistung erschließt sich umgehend. Statt mindestens 18 000 x 30 = 540 000 Vektoren mit der jeweiligen AKM der Messwerte vergleichen zu müssen, reicht es erfindungsgemäß aus, 18 000 x 2 = 36 000 2 x a dimensionale Arrayresponsekomponenten mit dem aktuellen Messwertobjekt zu vergleichen. Geschätzt ist der Rechenaufwand bei einer Projektion der Messwerte bezüglich solcher 2 x a dimensionalen Objekten bei einer geeigneten, nicht unbedingt exakten, Umsetzung um etwa den Faktor 4 höher als bei der Projektion bezüglich vorbekannter Vektoren mit a Zeilen. Damit ergibt sich im vorliegenden Beispiel eine mögliche Reduktion der Rechenleistung um etwa den Faktor 30 / 4 = 7,5.

Es ist sofort ersichtlich, dass dieser Faktor, ebenso wie die Speicherplatzersparnis umso größer wird, je höher die Auflösung und die Anzahl der berücksichtigten Parameter (wie Frequenz, Phase, Polarisation, Krümmung etc.) sind.

Die nötige Anzahl und Auswahl der Parameter wird durch die Ausdehnung der Empfangsvorrichtungsanordnung im Verhältnis zur Wellenlänge des zu analysierenden Wellenfeldes, die Umgebung und die Anforderung an die Auflösung und Genauigkeit bestimmt.

Um Eigenschaften des Wellenfeldes zuverlässig durch Projektion mehrdimensionaler Objekte bestimmen zu können, ist es jedoch erforderlich, dass sich das Problem näherungsweise linear verhält und so näherungsweise als entkoppelt betrachtet werden kann. Dies ist jedoch zumindest in eingeschränkten Bereichen in der Regel (näherungsweise) gegeben. So kann beispielsweise die Wellenfrontkrümmung entlang der Ausdehnung der Empfangsvorrichtungsanordnung näherungsweise bis etwa 10° als ausreichend linear angesehen werden. Für die Polarisation sind zumindest theoretische keine Einschränkungen zu machen.

Dazu kann es sich anbieten, vor der Leistungsberechnung weitere Transformationen auf die AKM anzuwenden, um beispielsweise Rauschen und Geistersignale zu unterdrücken.

Auf Grund der vorgehenden Ausführungen ist es dem Fachmann einleuchtend, dass das die Erfindung bei jeder Art von Wellen in allen Frequenzbereichen angewendet werden kann.

Bei der Wahl der Anzahl der Empfangsvorrichtungen ist auf ein ausgewogenes Verhältnis zu der Anzahl der zu einer Messwertmatrix zusammengefassten Messungen zu achten. Als geeignet haben sich beispielsweise die Verwendung von Frequenz, alpha und phi als Parameter der Arrayresponse bei 20 bis 40, insbesondere 32, Antennen a und 5 bis 25, insbesondere 8 bis 16, Messungen i der jeweils a Antennen für eine Messwertmatrix erwiesen. Als besonders vorteilhaft hat sich dabei erwiesen, i<a zu wählen, denn dann existieren typischerweise alle i EW ungleich null und besitzt der Eigenvektorraum somit die Dimension i.

Besonders vorteilhaft und mit eigenem Erfindungswert behaftet kann es je nach Einsatzzweck gemäß Anspruch 2 sein, das 2 x a dimensionale Objekt um zwei Dimensionen zu erweitern, wobei das Objekt in der dritten und vierten Dimension angibt, welches Signal der Empfangsvorrichtungsanordnung in Abhängigkeit von der Krümmung einer einfallenden Wellenfront einer elektromagnetischen Strahlung zu entnehmen ist.

Bevorzugt wird die die Abstandsberechnung gemäß Anspruch 3 über Projektion zwischen dem Eigenvektor(Unter)raum der Autokorrelationsmatrix AKM und der Arrayresponse durchgeführt. Die Verwendung des Eigenvektorraums der AKM oder vorzugsweise eines geeigneten Eigenvektorunterraums, also eines Unterraums des Eigenvektorraums, wie sie oben schon beschrieben wurde, ist besonders vorteilhaft, da so auf einfache Weise nicht zu beachtende Signalanteile, wie beispielsweise Rauschen oder Geistersignale, unterdrückt werden können. Eine Abstandberechung durch Projektion ist besonders vorteilhaft, da sie mit verhältnismäßig wenig Rechenzeit, vorzugsweise auch in Echtzeit, möglich ist. Dabei lässt sich auf einfache Weise durch die Projektion auch eine nächstgelegene Komponente der Arrayresponse bestimmen, durch die dann auf die Eigenschaften des einfallenden Wellenfeldes geschlossen werden kann. Durch ein solches vorgehen, kann das Wellenfeld effizient analysiert werden.

Bevorzugt kann gemäß Anspruch 4 auf Grund der auf Basis von aus Messwerten berechneten Eigenwerte eine Berechnung von zumindest relativen Leistungsobergrenzen für Wellenfeldanteile erfolgen.

Aus den EW, insbesondere der AKM, insbesondere aus den Verhältnissen der EW, lassen sich die Verhältnisse der aus den Richtungen der zugehörigen Eigenvektoren eingestrahlten Leistungen bestimmen. Ist des Weiteren die gesamte eingestrahlte Leistung bekannt, können daraus absolute Leistungen errechnet werden. Bei dieser Leistungsanalyse der EW erhält man genau die Leistungssumme aller Wellenfeldkomponenten entlang dem zugehörigen EV. Das ist damit gleichzeitig eine Leistungsobergrenze für jede Wellenfeldkomponente einzeln.

Diese Leistungsanalyse wird bevorzugt durch Division der Verhältnissen der EW durch das Quadrat je eines zugehörigen Linearkoeffizienten der in den (Unter)raum projizierten Arrayresponse oder Komponenten der projizierten Arrayresponse (z.B. sind x und y aus der obigen Ausführung zu T(z) = z · U1 + U2 solche Linearfaktoren), zumindest relative Leistungsobergrenzen von Wellenfeldanteilen ermittelt werden.

Es ist einleuchtend, dass durch Linearkombinationen auch die Leistungen aus jeder beliebigen Einfallsrichtung ermittelt werden können. Dies kostet jedoch vergleichsweise viel Rechenzeit und kann zu Schwierigkeiten, insbesondere unzuverlässigen Ergebnissen, führen, wenn auf Grund von Messungenauigkeiten Umgebungseinflüssen und/oder nicht vollständiger Auswertung, zum Beispiel aus Gründen der Rechenzeiteinsparung, nicht alle Wellenfeldanteile bekannt sind.

Besonders vorteilhaft, da Rechenzeit sparend und auch in oben genannten Problemfällen anwendbar, ist es daher, erfindungsgemäß nicht die exakten (relativen oder absoluten) Leistungen eines Wellenfeldanteils zu berechnen, sondern lediglich Leistungsobergrenzen zu berechnen. Also Werte zu berechnen, die Obergrenzen für die (relativen oder absoluten) Leistungen einzelner Wellenfeldanteile angeben. Dadurch müssen nicht mehr alle Linearkombinationen durchgerechnet werden. Die dadurch in Kauf genommenen Ungenauigkeiten können durch dem Fachmann bekannte Berechnungsmethoden im Verhältnis zur eingesparten Rechenzeit gering gehalten werden.

Bevorzugt ermittelt man die am besten zu den EV passenden Komponenten der Arrayresponse beziehungsweise die Parameter, die die Arrayresponsfunktion den EV möglichst gleich machen, also beispielsweise die lokalen Minima der Projektion. Im Anschluss stellt man diese Komponenten der Arrayresponse als Linearkombinationen der EV da, zerlegt sie also nach der Basis der EV. Dann geben die in den Zeilen stehenden komplexen Zahlen (Linearkoeffizienten) die Anteile der EV an den Komponenten der Arrayresponse an. Insbesondere bei Normierung der AKM und der Arrayresponse der Art, dass die Summe der Quadrate der EW 1 beträgt, können folgendermaßen Leistungsobergrenzen einfach berechnet werden, Abwandlungen sind dem Fachmann möglich: Man bildet die Verhältnisse aus EW und dem Quadrat des zugehörigen Linearkoeffizienten. Für jede Arrayresponsekomponente erhält man dadurch einen Satz von Verhältnissen, die relative Obergrenzen für die Leistung des Wellenfeldanteils passend zu der Arrayresponsekomponente angeben. Da es sich um Obergrenzen handelt, muss verständlicherweise nur das kleinste Verhältnis betrachtet werden.

Ermittelt man diese relative Obergrenze für alle oben als am besten passend (beispielsweise durch Bestimmung der lokalen Minima der Projektionsfunktion) ermittelten Arrayresponsekomponenten und kennt man auch die insgesamt eingestrahlt Leistung, lassen sich aus den relativen Werten absolute Werte berechnen.

Dieses Vorgehen ist besonders vorteilhaft, da in der Praxis die Eigenwerte oft sehr stark abfallen, das heißt es gibt wenige im Verhältnis zu den anderen EW große EW. Dadurch kann einfach ermittelt werden, welche Wellenfeldanteile weiter betrachtet werden sollen. Bei dieser Entscheidung kann auch das Wissen um das Auflösungsvermögen der Empfangsvorrichtung eingehen.

Durch ein solches Vorgehen lassen sich auch schnell Wellenfeldanteile identifizieren, die auf Grund von nur wenig möglicher Leistung (niedriger Leistungsobergrenze) für die weitere Auswertung weniger stark bewertet werden können.

Vorteilhaft ist dabei auch, dass die Leistungsobergrenzen bei der Abstandsberechnung schon fast mitberechnet werden können und im Gegensatz zu vorbekannten Verfahren kaum weiterer Rechenaufwand nötig ist.

Im Gegensatz zu den vorbekannten Verfahren, die auf Grundlage der Eigenvektoren einen Unterraum ermitteln, der als Signal betrachtet wird, und den komplementären Unterraum bei der Ermittlung der Eigenschaften des Wellenfeldes im Folgenden außer Acht lassen, und somit nur eine gewissen Menge von Eigenvektoren und Eigenwerten wirklich berücksichtigen, werden erfindungsgemäß auch alle Eigenwerte verwendet, um eine (relative), bevorzugt durch Obergrenzen genäherte, Verteilung der einfallenden Energie auf einzelne Einfallsrichtungen zu ermitteln. Dadurch wird es möglich, insbesondere die Einfallsrichtungen einzelner Anteile des Wellenfeldes, mit besonderer Genauigkeit zu bestimmen. Dabei kann je nach Anwendung die räumliche Energieeinfallsverteilung errechnet werden und/oder eine beziehungsweise einzelne besonders ausgezeichnete Einfallsrichtungen ermittelt werden.

Besonders vorteilhaft ist es, auf Grund der Eigenwerte die zumindest relativen Leistungen der Wellenfeldfeldanteile mit Einfallrichtung parallel zu den Eigenvektoren zu ermitteln. Dies spart Rechenzeit, da die zur Ermittlung der Leistung aus anderen Einfallsrichtungen nötigen Berechnungen von Linearkombinationen der Eigenvektoren entfallen können.

Besonders Rechenzeit und Speicherplatz sparend ist es, die Arrayresponse in orthogonalisierter Form zu verwenden, die einzelenen, insbesondere N x a dimensionalen, Arrayresponsekomponenten zu orthogonalisieren.

Besonders vorteilhaft ist es, die Abstandsberechnung durch Projektion der Arrayresponse in den Raum oder einen Unterraum der Autokorrelationsmatrix durchzuführen (wie beispielsweise durch die Projektion von T nach $T_p$). Dadurch können auf einfache Weise Abstände gewonnen werden. Aus ihnen können dann Eigenschaften des Wellenfeldes bestimmt werden. Zunächst wird dazu die zu den Messwerten näherungsweise passende (minimaler Abstand) (unter anderem Rauschen verhindert eine exakte Übereinstimmung) Arrayresponsekomponente bestimmt. An dieser können dann die Eigenschaften des eingestrahlten Wellenfeldes bestimmt werden, da jede Arrayresponsekomponente einer Kombination von Ausprägungen von Eigenschaften (z.B. Frequenz, Amplitude, Richtung) eines Wellenfeldes zugeordnet ist.

Die Aufgabe wird ebenfalls durch eine Vorrichtung gemäß Anspruch 9 gelöst.

Besonders vorteilhaft ist, wenn die Mittel zur Abstandsberechnung so ausgebildet sind, dass sie die Abstandsberechnung durch Projektion der Arrayresponse in den Raum oder einen Unterraum der Autokorrelationsmatrix durchführen (wie beispielsweise durch die Projektion von T nach $T_p$), insbesondere Objekte mit minimalem Abstand ermitteln,

Besonders bevorzugt ist die Verwendung von Eigenwerte der AKM von mindestens zwei nicht vollständig korrelierten Messwerten, insbesondere deren Verhältnissen, zur Ermittlung von zumindest relativen Leistungsobergrenzen von Wellenfeldanteilen, insbesondere durch Division der Eigenwerte durch das Quadrat je eines zugehörigen Linearkoeffizienten der in den (Unter)raum projizierten Arrayresponse.

Des weiteren können auf Basis einer Autokorrelationsmatrix von mindestens zwei nicht vollständig korrelierten Messwerten einer Empfangsvorrichtungsanordnung mit mindestens zwei Empfangsvorrichtungen berechnete Eigenwerte, insbesondere deren Verhältnisse, zur Ermittlung von zumindest relativen Leistungsobergrenzen von Wellenfeldanteilen verwendet werden.

Dabei erfolgt die Bestimmung vorzugsweise durch Division der Eigenwerte durch das Quadrat je eines zugehörigen Linearkoeffizienten der in den (Unter)raum projizierten Arrayresponse.

Bevorzugt kann ein Verfahren zur Analyse eines elektromagnetischen Wellenfeldes, insbesondere bezüglich mindestens einer Einfallsrichtung, eingesetzt werden bei dem eine aus mindestens zwei Messwerten einer Empfangsvorrichtungsanordnung mit mindestens zwei Empfangsvorrichtungen erstellte oder errechnete Autokorrelationsmatrix, verwendet wird, und bei dem auf Grundlage der Eigenwerte zumindest relative Leistungsobergrenzen der Wellenfeldfeldanteile ermittelt werden.

Durch die erfindungsgemäßen Lösungen können gegenüber vorbekannten Lösungen deutliche Vorteile in Bezug auf die Genauigkeit der Analyse, der Einsparung von Rechenleistung und Speicherplatz und den Platzerfordernissen der benötigten Empfangsvorrichtungsanordnungen realisiert werden. Dabei ist dem Fachmann sofort klar, dass durch die Einsparung von Rechenleistung und Speicherplatz bei gleicher Ausstattung höhere Genauigkeiten erzielt werden können beziehungsweise umgekehrt bei gegebener Genauigkeit Rechenleistung und Speicherplatz eingespart werden können. Gleiches gilt für den Platzbedarf der Empfangsvorrichtungsanordnung. Denn durch größere Empfangsvorrichtungsanordnungen können im Allgemeinen bei ansonsten gleichen Umständen höhere Genauigkeiten erzielt werden.

Eine besondere Einsparung von für die Empfangsvorrichtungsanordnung benötigtem Platz kann durch diese Erfindung aber dadurch erreicht werden, dass nicht nur eine Arrayresponse größerer Genauigkeit verwendet wird, sondern auch die Vielzahl der durch Empfangsvorrichtungen gelieferten Informationen besser ausgewertet werden können. Denn bei gleicher Rechleistung können deutlich mehr Parameter (Frequenz, Krümmung etc.) abgeglichen werden, als das mit Vorbekanntem möglich ist.

Die vorgehende Beschreibung der Erfindung hat deutlich gemacht, wie die Aufgabe zu lösen ist und welche Vorteile sich daraus unter anderem ergeben. Die genaue Ausgestaltung erschließt sich, wie auch Abwandlungen, die nicht vom Kern der Erfindung weg führen, dem Fachmann auf Grund seines Wissens.

Nachfolgend soll nun anhand der Figur eine beispielhafte Ausführung beschrieben werden, auf die die Erfindung jedoch nicht beschränkt ist. Das Beispiel soll vielmehr einen möglichen Weg zur Umsetzung der Erfindung beschreiben.

Dabei zeigt:

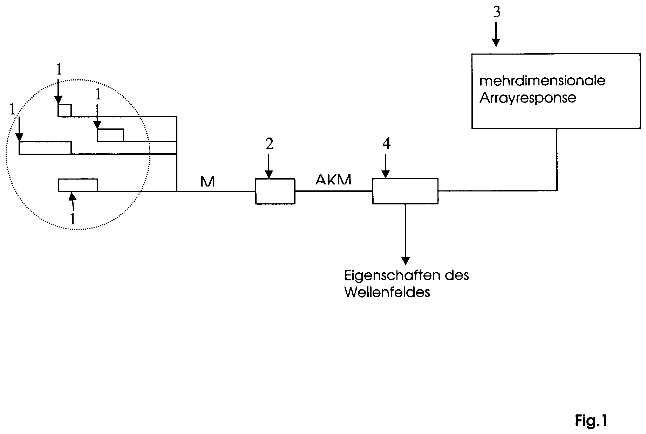

Fig. 1 einen schematischen Aufbau einer erfindungsgemäßen Vorrichtung.

Die Zeichnung stellt lediglich eine schematische Abbildung da. Die genauere Ausgestaltung erschließt sich dem Fachmann, wie auch Abwandlungen.

Die Erfindung ist insbesondere nicht auf die Figur oder das Ausführungsbeispiel beschränkt.

Die Empfangsvorrichtungen 1 bilden die Empfangsvorrichtungsanordnung. In diesem Ausführungsbeispiel sind die Empfangsvorrichtungen 1 a Antennen für elektromagnetische Strahlung, bevorzugt a=32. Aber auch jede andere Anzahl größer eins ist denkbar. Die Antennen weisen unterschiedliche Polarisationsrichtungen und Abstrahlcharakteristika auf. Die Signale der Antennen werden digitalisiert (hier nicht gezeigt) und in ein Messwertobjekt M, bestehend aus jeweils i Messungen der a Antennen, zusammengefasst (nicht summiert), wobei i bevorzugt zwischen 8 und 16 liegt, aber auch jede Anzahl in einem deutlich größeren Bereich möglich ist. In diesem Ausführungsbeispiel sind dabei je eine komplexe Zahl (Messwert) mit Informationen über Amplitude und Phase für jede der i Messungen und jede der a Antennen enthalten. Es liegen also im Sprachgebrauch dieser Schrift komplexe, mehrdimensionale Messwertobjekte, effektiv also pro Zeiteinheit jeweils eine komplexe Matrix der Größe a x i vor. Diese Messwertmatrix wird in der ersten Berechnungseinheit 2 mit sich selbst korreliert. Dadurch wird die AKM erzeugt.

Im Speicher 3 befindet sich die hier, im Sprachgebrauch der Anmeldung, Arrayresponse bestehend aus einer Vielzahl von 2 x a Matrizen, den Arrayresponsekomponenten. Die AKM wird in der zweiten Berechungseinheit 4 in den durch die Arrayresponsekomponenten aufgespannten Raum projiziert und das zur AKM nächstliegende Objekt in diesem Raum wird ermittelt.

Daraus werden, ebenfalls in der zweiten Berechnungseinheit 4, die Eigenschaften des Wellenfeldes ermittelt, das sich näherungsweise aus einer Linearkombination der den einzelnen Arrayresponsekomponenten Wellenfeldern zusammensetzt. Da die einzelnen Ausprägungen von Eigenschaften der den Arrayresponsekomponenten zugeordneten Wellenfeldanteilen bekannt sind, kann aus deren Linearkombinationen das jeweils aktuell vorliegende Wellenfeld näherungsweise bestimmt werden.

Probleme treten verständlicherweise dann auf, wenn nichtlineare Effekte merklich die Eigenschaften des Wellenfeldes prägen, da dann die einzelnen Wellenfeldanteile nicht mehr durch lineare Zerlegung des Wellenfeldes errechnet werden können. Jedoch sind solche nichtlinearen Effekte in den meisten Anwendungsbereichen vernachlässig- oder beherrschbar.

Somit kann in der Regel das Wellenfeld mit äußerster Genauigkeit analysiert werden und somit beispielsweise die Belastung durch elektromagnetische Strahlung differenziert beurteilt oder die Lage von Quellen relativ zur Empfangsvorrichtungsanordnung analysiert und/oder Wellenfeldanteile unterschiedlicher Quellen voneinander getrennt werden.

Bezugszeichenliste:

1 Empfangsvorrichtung
2 erste Berechnungseinheit
3 Speicher
4 zweite Berechnungseinheit

**Patentansprüche**

1. Verfahren zur Analyse eines elektromagnetischen Wellenfeldes, insbesondere bezüglich mindestens einer Einfallsrichtung bei dem eine aus mindestens zwei nicht vollständig korrelierten Messwerten einer Empfangsvorrichtungsanordnung erstellte oder errechnete Autokorrelationsmatrix (AKM) und eine aus Berechnung oder Kalibrationsmessungen gewonnene Arrayresponse der Empfangsvorrichtungsanordnung verwendet werden, um durch Abstandsberechnung zwischen Autokorrelationsmatrix und Arrayresponse mittels Projektion und Bestimmung der nächstliegenden Arrayresponse aus der nächstliegenden Arrayresponse die Einfallsrichtung, die Polarisation, die Phase und/oder die Krümmung von einem oder mehreren Wellenfeldanteilen zu ermitteln, wobei die Arrayresponse von mindestens einer Eigenschaft einer einfallenden Welle abhängt und eine N x a dimensionale Matrix-Funktion, deren einzelne N x a Werte jeweils von mindestens einer Eigenschaft der einfallenden Welle abhängig sind, oder einer Menge von N x a dimensionalen Matrizen ist, die jeweils einer Kombination der Ausprägung mindestens einer Eigenschaft der einfallenden Welle zugeordnet sind, wobei a die Anzahl der Empfangsvorrichtungen ist und a> =2 und N > = 2 ist.

2. Verfahren nach Anspruch 1 **dadurch gekennzeichnet, dass** N = 2 ist und die Arrayresponse in der ersten Zeile die komplexen Responsen der a Antennen beim Einfall einer im Winkel p1 polarisierten Welle und in der zweiten Zeile die komplexen Responsen der a Antennen beim Einfall einer im Winkel p2 polarisierten Welle aufweist und/oder die Arrayresponse 2-dimensionale Räume aufspannt und dadurch unabhängig von der Eigenschaft der Polarisation ist.

3. Verfahren nach Anspruch 1 **dadurch gekennzeichnet, dass** N = 4 ist ist und wobei die Arrayresponse in der dritten und vierten Dimension angibt, welches Signal der Empfangsvorrichtungsanordnung in Abhängigkeit von der Krümmung einer einfallenden Wellenfront einer elektromagnetischen Strahlung zu entnehmen ist und/oder die Arrayresponse 4-dimensionale Räume aufspannt und dadurch (näherungsweise) unabhängig von den Eigenschaften Polarisation und Frequenz oder von den Eigenschaften Polarisation und Krümmung der Wellenfront ist.

4. Verfahren nach einem der vorhergehenden Asprü-

che **dadurch gekennzeichnet, dass** die Abstandsberechnung über Projektion zwischen einem Unterraum und/oder dem Eigenvektor(Unter)raum der Autokorrelationsmatrix (AKM) und der Arrayresponse erfolgt.

5. Verfahren nach einem der vorhergehenden Ansprüche **dadurch gekennzeichnet, dass** aus den Eigenwerten der Autokorrelationsmatrix (AKM), insbesondere aus deren Verhältnissen, insbesondere durch Division durch das Quadrat je eines zugehörigen Linearkoeffizienten der in den (Unter)raum projizierten Arrayresponse, zumindest relative Leistungsobergrenzen von Wellenfeldanteilen ermittelt werden.

6. Verfahren nach einem der vorhergehenden Ansprüche **dadurch gekennzeichnet, dass** die einzelnen Arrayresponsekomponenten orthogonalisiert sind und/oder dass die Abstandsberechnung durch Projektion der Arrayresponse auf den (Unter)raum, insbesondere Eigenwert(Unter)raum der Autokorrelationsmatrix (AKM) erfolgt.

7. Verfahren nach einem der vorhergehenden Ansprüche, **dadurch gekennzeichnet, dass** die Arrayresponse 8-dimensionale Räume aufspannt und dadurch (näherungsweise) unabhängig von den Eigenschaften Polarisation und Frequenz und Krümmung der Wellenfront ist.

8. Verfahren nach einem der vorhergehenden Ansprüche, **dadurch gekennzeichnet, dass** die Dimension der durch die Arrayresponse aufgespannten Räume durch mindestens eine Approximation reduziert ist.

9. Vorrichtung zur Analyse eines elektromagnetischen Wellenfeldes beinhaltend a Empfangsvorrichtungen (1) und eine gespeicherte Arrayresponse der Empfangsvorrichtungen (1) oder Mittel zu deren Berechnung und Mittel zur Berechnung oder Erstellung der Autokorrelationsmatrix, mindestens zweier nicht vollständig korrelierter Messwerte der Empfangsvorrichtungen (1) und Mittel zur Abstandsberechnung zwischen Autokorrelationsmatrix und Arrayresponse, insbesondere über Projektion, insbesondere zwischen einem Unterraum der Autokorrelationsmatrix und der Arrayresponse, zur Ermittlung der Einfallsrichtung, der Polarisation, der Phase und/oder der Krümmung von einem oder mehreren Wellenfeldanteilen, wobei die Arrayresponse eine N x a dimensionale Matrix-Funktion, deren einzelne N x a Werte jeweils von mindestens einer Eigenschaft einer einfallenden Welle abhängig sind, oder einer Menge von N x a dimensionalen Matrizen ist, die jeweils einer Kombination der Ausprägung mindestens einer Eigenschaft einer einfallenden Welle zugeordnet sind, wobei a die Anzahl der Empfangsvorrichtungen ist und a > = 2 und N > = 2 ist.

10. Vorrichtung nach Anspruch 9, **dadurch gekennzeichnet, dass** die Mittel zur Abstandsberechnung die Abstandsberechnung durch Projektion der Arrayresponse auf den (Unter)raum der Autokorrelationsmatrix (AKM) durchführen.

11. Verfahren nach Anspruch 1, wobei das Verfahren auch ein Verfahren zur Analyse eines elektromagnetischen Wellenfeldes bezüglich mindestens einer Einfallsrichtung, bei dem eine aus mindesten zwei nicht vollständig korrelierten Messwerten einer Empfangsvorrichtungsanordnung mit mindestens zwei Empfangsvorrichtungen erstellte oder errechnete Autokorrelationsmatrix verwendet wird, **dadurch gekennzeichnet, dass** auf Grund der Eigenwerte der Autokorrelationsmatrix zumindest relative Leistungsobergrenzen für aus unterschiedlichen Richtungen einfallende Wellenfeldanteile ermittelt werden.

## Claims

1. A method for analysing an electromagnetic wave field, in particular with regard to at least one direction of incidence, using an autocorrelation matrix (AKM) created or calculated from at least two measured values of a receiving device arrangement that are not completely correlated and an array response of the receiving device arrangement obtained from calculation or calibration measurements, in order to obtain the direction of incidence, the polarisation, the phase and/or the curvature of one or more wave field components by calculating the distance between the autocorrelation matrix and the array response by means of projection and determination of the closest array response, wherein the array response depends on at least one property of an incident wave and an N x a dimensional matrix function whose individual N x a values are each dependent on at least one property of the incident wave, or a set of N x a dimensional arrays, each associated with a combination of the expression of at least one property of the incident wave, where a is the number of receiving devices and a> = 2 and N> = 2.

2. The method according to Claim 1, **characterised in that** N = 2 and the array response in the first line exhibits complex responses of the a antennas upon the incidence of a wave polarised at angle p1 and in the second line exhibits complex responses of the a antennas upon the incidence of a wave polarised at angle p2 and/or the array response spans 2-dimensional spaces and is thus independent of the property of the polarisation.

**3.** The method according to claim 1, **characterised in that** N = 4 and wherein the array response in the third and fourth dimensions indicates which signal of the receiving device array is to be taken in response to the curvature of an incident wavefront of electromagnetic radiation and/or the array response spans 4-dimensional spaces and is thereby (substantially) independent, regardless of the characteristics of polarisation and frequency or by the properties of polarisation and curvature of the wavefront.

**4.** The method according to one of the preceding claims, **characterised in that** the distance calculation is performed by projection between a subspace and/or the eigenvector (sub) space of the autocorrelation matrix (AKM) and the array response.

**5.** The method according to one of the preceding claims, **characterised in that** at least relative power upper limits of wavefield components are determined from the eigenvalues of the autocorrelation matrix (AKM), in particular from their ratios, in particular by dividing by the square of each associated linear coefficient of the array response projected into the (sub) space.

**6.** The method according to one of the preceding claims, **characterised in that** the individual array response components are orthogonalized and/or that the distance calculation is performed by projection of the array response to the (sub) space, in particular eigenvalue (sub) space of the autocorrelation matrix (AKM).

**7.** The method according to one of the preceding claims, **characterised in that** the array response spans 8-dimensional spaces and is therefore (substantially) independent of the properties polarisation and frequency and curvature of the wavefront.

**8.** The method according to one of the preceding claims, **characterised in that** the dimension of the spaces spanned by the array response is reduced by at least one approximation.

**9.** The device for analysing an electromagnetic wave field comprising a receiving devices (1) and a stored array response of the receiving devices (1) or means for calculating them and means for calculating or generating the autocorrelation matrix, at least two not completely correlated measured values of the receiving devices (1) and means for distance calculation between autocorrelation matrix and array response, in particular via projection, in particular between a subspace of the autocorrelation matrix and the array response, for determining the direction of incidence, the polarisation, the phase and/or the curvature of one or more wave field components, wherein the array response is a N x a dimensional matrix function, whose individual N x a values are each dependent on at least one property of the incident wave, or a set of N x a dimensional arrays, each associated with a combination of the expression of at least one property of the incident wave, where a is the number of receiving devices and a> = 2 and N> = 2.

**10.** The apparatus according to claim 9, **characterised in that** the distance calculation means perform the distance calculation by projection of the array response onto the (sub) space of the auto-correlation matrix (AKM).

**11.** The method of claim 1, wherein the method also includes a method of analysing an electromagnetic wave field with respect to at least one incident direction using an autocorrelation matrix created or calculated from at least two non-fully correlated measurements of a receiving device array with at least two receiving devices, **characterised in that** based on the eigenvalues of the autocorrelation matrix at least relative upper power limits are determined for wave field components incident from different directions.

**Revendications**

**1.** Procédé d'analyse d'un champ d'ondes électromagnétiques, en particulier en ce qui concerne au moins une direction d'incidence, utilisant une matrice d'autocorrélation (AKM) créée ou calculée à partir d'au moins deux valeurs mesurées d'un dispositif récepteur non complètement corrélé et d'une réponse matricielle de la disposition des appareils récepteurs obtenue à partir de mesures de calcul ou d'étalonnage, afin d'obtenir la direction d'incidence, la polarisation, la phase et/ou la courbure d'une ou de plusieurs composantes de champ d'onde en calculant la distance entre la matrice d'autocorrélation et la réponse matricielle par projection et détermination de la réponse matricielle la plus proche, dans lequel la réponse matricielle dépend d'au moins une propriété d'une onde incidente et d'une fonction matricielle dimensionnelle N x a dont les valeurs N x a individuelles dépendent chacune d'au moins une propriété de l'onde incidente, ou d'un ensemble de N x a matrices dimensionnelles, chacun étant associée à une combinaison de l'expression d'au moins une propriété de l'onde incidente, où a est le nombre d'appareils récepteurs et a> = 2 et N> = 2.

**2.** Procédé selon la revendication 1, **caractérisé en ce que** N = 2 et la réponse matricielle dans la première ligne présente des réponses complexes des a antennes sur l'incidence d'une onde polarisée à l'angle p1 et la seconde deuxième ligne présente des réponses complexes des a antennes sur l'incidence d'une onde polarisée à l'angle p2 et/ou la réponse matricielle couvre des espaces à deux dimensions et est donc indépendante de la propriété de la polarisation.

3. Procédé selon la revendication 1, **caractérisé en ce que** N = 4 et dans lequel la réponse matricielle dans les troisième et quatrième dimensions indique quel signal du réseau d'appareils récepteurs doit être considéré en réponse à la courbure d'un front d'onde incident de rayonnement électromagnétique et/ou la réponse matricielle couvre des espaces à 4 dimensions et est ainsi (plus ou moins) indépendante, quelles que soient les caractéristiques de polarisation et de fréquence ou des propriétés de polarisation et de courbure du front d'onde.

4. Procédé selon l'une des revendications précédentes, **caractérisé en ce que** le calcul de la distance est effectué par projection entre un sous-espace et/ou le (sous-espace) vecteur propre de la matrice d'autocorrélation (AKM) et la réponse matricielle.

5. Procédé selon l'une des revendications précédentes, **caractérisé en ce que** les limites supérieures de puissance relative au moins des composantes de champ d'ondes sont déterminées à partir des valeurs propres de la matrice d'autocorrélation (AKM), en particulier par rapport au carré de chaque coefficient linéaire associé de la réponse matricielle projetée dans le (sous) espace.

6. Procédé selon l'une des revendications précédentes, **caractérisé en ce que** les composantes de réponse matricielle individuelles sont rendues orthogonales et/ou que le calcul de distance est effectué par projection de la réponse matricielle au (sous) espace, en particulier le (sous) espace de valeur propre de la matrice d'autocorrélation (AKM).

7. Procédé selon l'une des revendications précédentes, **caractérisé en ce que** la réponse matricielle couvre des espaces à 8 dimensions et est donc (plus ou moins) indépendante des propriétés de polarisation et de fréquence et de courbure du front d'onde.

8. Procédé selon l'une des revendications précédentes, **caractérisé en ce que** la dimension des espaces engendrés par la réponse du réseau est réduite d'au moins une approximation.

9. Dispositif d'analyse d'un champ d'ondes électromagnétiques comprenant des appareils récepteurs (1) et une réponse matricielle stockée des appareils récepteurs (1) ou des moyens pour les calculer et des moyens pour calculer ou générer la matrice d'autocorrélation, au moins deux valeurs mesurées non complètement corrélées des appareils récepteurs (1) et des moyens de calcul de distance entre la matrice d'autocorrélation et la réponse matricielle, en particulier par projection, en particulier entre un sous-espace de la matrice d'autocorrélation et la réponse matricielle, pour déterminer la direction d'incidence, la polarisation, la phase et/ou la courbure d'une ou de plusieurs composantes de champ d'onde, dans lequel la réponse matricielle est une fonction matricielle dimensionnelle N x a dont les valeurs N x a individuelles dépendent chacune d'au moins une propriété de l'onde incidente, ou d'un ensemble de N x a matrices dimensionnelles, chacune étant associée à une combinaison de l'expression d'au moins une propriété de l'onde incidente, où a est le nombre d'appareils récepteurs et a> = 2 et N> = 2.

10. Appareil selon la revendication 9, **caractérisé en ce que** les moyens de calcul de distance effectuent le calcul de distance par projection de la réponse du réseau sur le (sous) espace de la matrice d'autocorrélation (AKM).

11. Procédé selon la revendication 1, dans lequel le procédé comprend également un procédé d'analyse d'un champ d'onde électromagnétique par rapport à au moins une direction incidente en utilisant une matrice d'autocorrélation créée ou calculée à partir d'au moins deux mesures non entièrement corrélées d'un ensemble d'appareils récepteurs avec au moins deux appareils récepteurs, **caractérisé en ce qu'**au moins des limites supérieures de puissance relatives sont déterminées pour des composantes de champ d'onde incidentes dans des directions différentes, sur la base des valeurs propres de la matrice d'autocorrélation.

**Fig.1**